# EUROPEAN PATENT APPLICATION

(11) **EP 2 819 159 A1**
(43) Date of publication of application: **31.12.2014**
(21) Application number: 13305904.8
(22) Date of filing: 27.06.2013
(51) Int. Cl.: H01L 23/473, H01L 23/427

(54) **Cooling technique**

(71) Applicant: ALCATEL LUCENT, 92100 Boulogne-Billancourt (FR)
(72) Inventor: Jeffers, Nicholas, 15 Dublin (IE); Donnelly, Brian, 15 Dublin (IE); Daly, John, 15 Dublin (IE)
(74) Representative: Shamsaei Far, Hassan

(57) **Abstract**

A cooling apparatus is disclosed having an air conduit with a thermally conductive wall. The apparatus further comprises an air mover located adjacent to an end of the air conduit. The air mover is configured to cause air to flow through the air conduit. A heat transfer assembly comprising the cooling apparatus is also disclosed.

## Description

The present disclosure relates to cooling techniques. One non-limiting application of the cooling technique is in electronic devices in which heat is generated during operation.

### BACKGROUND

A current tendency in the design and manufacture of electronic devices is to reduce their size (or volume) and weight. This task becomes more and more challenging as devices with reduced size are required to process increased rates of data which in turn generates higher amounts of heat. Furthermore, such heat is typically generated within a compact and component-dense volume of such devices which makes the task of cooling of these devices still more challenging.

### SUMMARY

The tendency in reducing size and weight has given rise, in some cases, to requirements established within certain industries or services with which manufacturers typically need to comply. For example, in some wireless applications, telecommunications operators have established strict design guidelines for health and safety which require that certain products, such as multi-band remote radio-heads, be designed with a weight of less than 10 kgs. Complying with this requirement may in practice become challenging for a manufacturer of such equipment.

To reduce the size (or volume) of these equipment, some known solutions are based on passive cooling techniques, for example using a hidden heat sink. Such hidden heat sink differs from conventional heat sinks in that it typically does not include large visible finned cooling structures. This solution, in addition to reducing size, is also of certain marketing interest because it enables the design of a device which is aesthetically pleasing for use in areas visible by the general public. However, as the devices are designed with smaller volumes, the passive solutions may become insufficient for performing an efficient cooling.

As an alternative potential solution to the size/volume problem, the use of rotary fans has been proposed. Herein, reference to the term rotary fan is to be understood to relate to an apparatus having vanes or blades or the like, connected to a rotor and capable of producing airflow by rotating the vanes in response to the action of the rotor. However there are drawbacks associated to the use of fans as they are typically inherently unreliable with short life times (e.g. of about 7 years). Furthermore, the cost of ownership of equipment with fans is typically high and they require a relatively large volume.

Embodiments of the disclosure feature a cooling apparatus comprising an air conduit and an air mover configured to generate and drive entrained air through an internal region of the air conduit, the air conduit comprising a thermally conductive wall configured to transfer heat from a surrounding medium to said internal region to dissipate the heat by a flow of the entrained air.

According to some specific embodiments, the thermally conductive wall of the air conduit has a thermal conductivity greater than about 1 W/mK.

According to some specific embodiments, the air mover is positioned at a separation distance from an end of the air conduit.

According to some specific embodiments, the separation distance is determined based on a rate of the air flow generated by the air mover and/or a length of the air conduit along a direction of flow of the air in the air conduit.

According to some specific embodiments, the separation distance is measured in terms of the hydraulic diameter of an air outlet of the air mover wherein the hydraulic diameter is four times the cross sectional area divided by the perimeter of the air outlet of the air mover.

According to some specific embodiments, the separation distance has a value between about 0.5 to about 5 times the hydraulic diameter.

According to some specific embodiments, the air mover is configured to generate a shear layer having an effective cross-sectional area being substantially equal to a cross-sectional area of the end of the air conduit.

According to some specific embodiments, an air conduit comprises an interior surface having roughness and/or additional structures within the air conduit. According to some specific embodiments, an air conduit comprises an exterior surface having roughness and/or additional structures on an outer surface of the air conduit.

Some embodiments of the disclosure feature a heat transfer assembly comprising the cooling apparatus as featured herein.

According to some specific embodiments, the heat transfer assembly comprises a housing and an air mover of the cooling apparatus is located at a separation distance from the housing.

According to some specific embodiments, the housing is in the form of a solid block of a thermally conductive heat spreading material.

According to some specific embodiments, the housing is hollow in the form of a cavity.

According to some specific embodiments, the housing is sealed and is filled with a liquid wherein the liquid surrounds the air conduits, the liquid having dielectric properties.

According to some specific embodiments, the housing is sealed and is partially filled with a liquid and at least one air conduit is not located inside the liquid. According to some specific embodiments, the heat transfer assembly comprises a liquid/vapor chamber.

These and further features and advantages of the present disclosure are described in more detail, for the purpose of illustration and not limitation, in the following description as well as in the claims with the aid of the accompanying drawings.

### BRIEF DESCRIPTION OF THE DRAWINGS

Figure 1 is an exemplary schematic representation of elements of a cooling apparatus according to some embodiments.
Figures 2a and 2b are exemplary schematic representations of a heat transfer assembly according to some embodiments.
Figure 3 is an exemplary schematic representation of a heat transfer assembly according to some embodiments.
Figure 4 is an exemplary schematic representation of a heat transfer assembly according to some embodiments.

### DETAILED DESCRIPTION

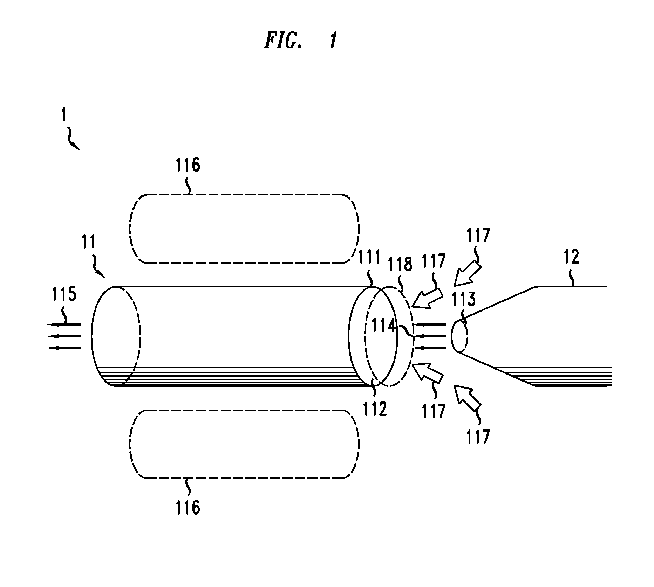

In figure 1 exemplary elements of a cooling apparatus 1 according to embodiments of the disclosure are shown. The cooling apparatus comprises an air conduit 11 having a thermally conductive wall 111. In the example shown in figure 1, the air conduit 11 is represented as a cylindrical body. However, the air conduit may have any suitable shape and size.

For the sake of clarity with respect to the use of the term thermal conductivity as used herein, the following clarification is provided. As it is known, many materials, and even from a pure theoretical standpoint any material, may be considered to be thermally conductive as each material has a certain level of thermal conductivity, even if in some cases such level is very low. However, within the context of the present disclosure, a person skilled in the related art would be able to distinguish a material which is considered in the art as thermally conductive from one which is not so considered, such as for example a thermal insulator.

By way of still further clarification, it is noted that within the context of the present disclosure, any material having a thermal conductivity greater than about 1W/mK (Watts per Meter Kelvin) may be considered as a thermally conductive material. Conversely, any material having a thermal conductivity of less than about 1W/mK may be considered as thermally non-conductive. Within the thermal conductivity range described above, a thermal conductivity greater than 100W/mK may be considered as a high thermal conductivity value and one within the range of 1-100W/mK may be considered as an acceptable value.

In the present case therefore, the thermally conductive wall of the air conduit may be of any known material as described above; for example it may be made of metal such as copper. Alternatively non-metal material may also be used such as conductive ceramics or graphene. Still alternatively, a suitable composite with metal, diamond or graphene may also be used.

The thermally conductive wall may be in any suitable form. For example the wall may be curved such as in an air conduit of cylindrical shape or flat such as in an air conduit of prismatic shape.

The apparatus further comprises an air mover 12 located adjacent to an end 112 of the air conduit 11. The air mover 12 is configured to eject air from an outlet 113, such as a nozzle. The flow of air as a result of the operation of the nozzle is illustratively shown via arrows 114. The air ejected by the nozzle 113 is forced to flow through an interior region of the air conduit 11 and exit from an opposite end of air conduit to an outside medium as illustratively shown by arrows 115. The flow of the air through the air conduit may contribute to the transfer of heat from the thermally conductive wall 111 out of the air conduit 11. In this manner, heat present in the outer medium 116 surrounding, or close to the air conduit, may be absorbed by the conductive wall 111 and transferred to the internal region of the air conduit 111 where it is dissipated by being forced to move out of the air conduit 11 by the flow of the air in the internal region of the air conduit 11 which is caused by the air mover 12 as described above.

The air mover 12 may have any suitable shape, size and material suitable for the intended use as described herein.

Preferably the air mover is an air jet. By the expression "air jet" it is meant to refer to any device capable of generating a rapid stream of air into a surrounding medium. The air jet may comprise a nozzle or similar outlet for the exit of air from the jet to the surrounding.

Preferably the air jet is configured such that it generates an airflow which has a significantly higher velocity (or momentum) as compared to the surrounding medium.

In the non-limiting example shown in figure 1, the air mover is represented in the form of an air jet 12 having a nozzle 113. However other configurations may also be used for the intended purpose as described herein. For example the air mover may be made using a piezoelectric fan which may be provided with a suitable enclosure and/or any other structure to ensure satisfactory operation of the piezoelectric fan.

In the example shown in figure 1, it is assumed that the medium surrounding the air jet 12 is air.

In operation, the airflow generated by the air jet 12 exits the nozzle 113 with a velocity V1 (not shown). The surrounding ambient air may be assumed to have an initial velocity V2 (not shown, which in many practical applications may be zero). For a satisfactory operation, V1 is larger than V2.

Due to the higher velocity of air 114 exiting the nozzle 113 relative to the ambient air 117, air entrainment may occur. This interaction generates turbulence, resulting in mixing portions of the surrounding ambient air within the airflow generated by the air jet 12. The entrained air is then forced to flow inside the air conduit 11. The air entrainment effect may contribute to further improve the heat transfer efficiency as it gives rise to a larger volumetric flow rate within the air conduit 11.

The terms "entrain" or "entrainment", as used herein, are known to a person of ordinary skill in the related art. As a non-limiting description, these terms may be understood to relate to a situation in which the movement of one fluid (in this case air) causes another surrounding fluid (also air, in this case) to move in the same general direction. The overall result of such action is to obtain a flow with the combination of the two fluids which in practice may have a higher volume or higher velocity of the flow. In the present case, at least one effect of air entrainment is that of producing a wider (larger diameter) air front 118 which is to be forced though the air conduit 11.

The arrangement shown in figure 1 is in fact a simple exemplary embodiment which comprises a single metal tube, for example made of copper which is heated on the external surface of the thermally conductive wall 111 and cooled by internal turbulent airflow 118 generated by the air jet 12.

As mentioned above, the operation of this arrangement may be made more efficient, for example, by having the nozzle 113 positioned such that ambient air 117 is entrained before entering the tube. This positioning may therefore require a certain separation between the nozzle 113 and the end 112 of the air conduit 11. Such separation distance may be determined according to the design requirements of the cooling apparatus. In determining the separation distance the geometry of the air mover (in particular the nozzle), the rate of the air flow, the length of the air conduit may be taken into account. In some cases the separation distance may be measured in terms of the hydraulic diameter of the nozzle's air outlet. For example the separation distance may be in the region of 0.5 to 5 hydraulic diameters, where the hydraulic diameter is defined as the four times the cross sectional area divided by the perimeter of the nozzle.

Preferably, the operation of the arrangement may further be optimized when the effective cross-sectional area of the shear layer generated at the air outlet of the nozzle 113 matches the cross-sectional area of the air conduit 11 before entering said structure.

Herein, a shear layer is to be understood to relate to a layer where the main airflow from the air jet interacts with the stagnant ambient air. This interaction between the moving and stagnant air generates the shear layer. Considering that the flow at the entrance of the air conduit has a certain original diameter of flow front, such diameter may increase as a result of the shear layer generated and the interaction between the air exiting the air jet and the stagnant air. Therefore, if the increased flow front diameter is matched to the diameter at the entrance of the air conduit, one may ensure an improved flow of the air closer to the wall (or walls) of the air conduit, thereby optimizing the performance of the device.

The above cooling apparatus may be implemented in a variety of ways for constructing heat transfer assemblies such as heat sinks. In such applications, a cooling apparatus as described above may be integrated within a heat transfer assembly.

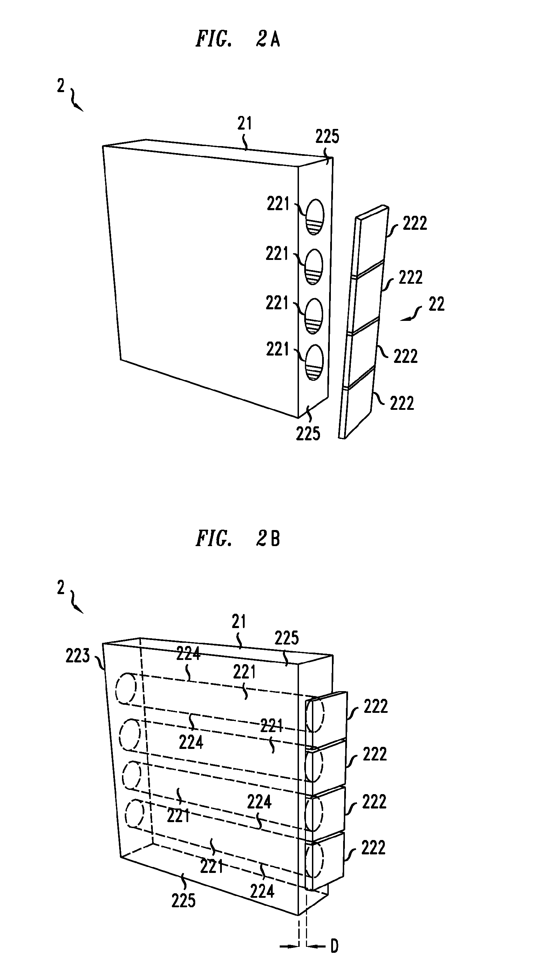

Figures 2a and 2b show an exemplary schematic representation of a heat transfer assembly 2 according to some embodiments. The heat transfer assembly 2 comprises a heat sink housing 21 (herein, housing) and a plurality of cooling apparatuses generally represented by reference numeral 22 (figure 2a). A cooling apparatus from the plurality of cooling apparatuses 22 comprises a respective air conduit 221 and a respective air mover 222 such that an air mover 222 is associated with an air conduit 221 to thereby form a cooling apparatus as described above with reference to figure 1. In the example shown in figure 2a, a plurality of air conduits 221 is shown to be installed within the housing 21 in the form of cylindrical tubes (more clearly shown in figure 2b). The plurality of air movers 222 is shown in figure 2a in an unassembled situation with respect to the housing 21 and in assembled situation in figure 2b. When assembled, the air movers 222 are preferably located at a separation distance from the housing 21, or from the air conduits 221, so as to allow air entrainment from the surrounding ambient. Such separation distance is illustratively shown in figure 2b by reference D and may be determined according to the criteria mentioned above with reference to figure 1.

The housing may be manufactured using known techniques such as for example an extrusion process.

Referring to figure 2b, the heat transfer assembly 2 is shown using simple linear representations and with the plurality of the air movers 222 assembled on the housing 21 such that individual air movers 222 are positioned adjacent to an end of a respective air conduits 221.

The air conduits 221 may be provided inside the body of the housing 21 in the form of through holes. This is more clearly shown in figure 2b is which each air conduit 221 has a cylindrical shape and extends from one side of the housing 21 where the air movers 222 are located to the opposite side 223 of the housing where the air is made to exit the hollow strictures 221.

In some embodiments, the housing 21 may be made in the form of a solid block of a thermally conductive heat spreading material such as a metal. In such embodiments, the regions denoted by reference numerals 225 are solid and the air conduits are defined as through holes within the solid body of the housing, with the wall (111, figure 1) of an air conduit being a surface inside the solid block of the housing enclosing the air conduit within the housing 21. Such surfaces are more clearly shown in figure 2b by reference numerals 224.

Such embodiments may be envisaged for uses in applications between electronics boards. In one exemplary practical implementation, a heat transfer assembly may be formed using an aluminum block (e.g. about 90mm x 90mm x 20mm) with four cylindrical holes (e.g. about 12.5mm diameter) drilled through the block of the housing 21 to define the air conduits 221 and an air jet nozzle of about 1.6mm outlet diameter may be located about 5mm upstream of each cylindrical hole.

In some embodiments, the housing 21 itself may be hollow in the form of a cavity in which air conduits 221 are located. In such embodiments, the regions denoted by reference numerals 225 are hollow and the air conduits 221 are defined as structures located within the housing, with the wall (111, figure 1) of the air conduit being a structure made of a thermally conductive material enclosing a space which defines the air conduit within the housing 21. Here again, such structures are more clearly shown in figure 2b by reference numerals 224.

Such embodiments may be envisaged for uses in applications in which the heat transfer assembly may use liquid cooling techniques.

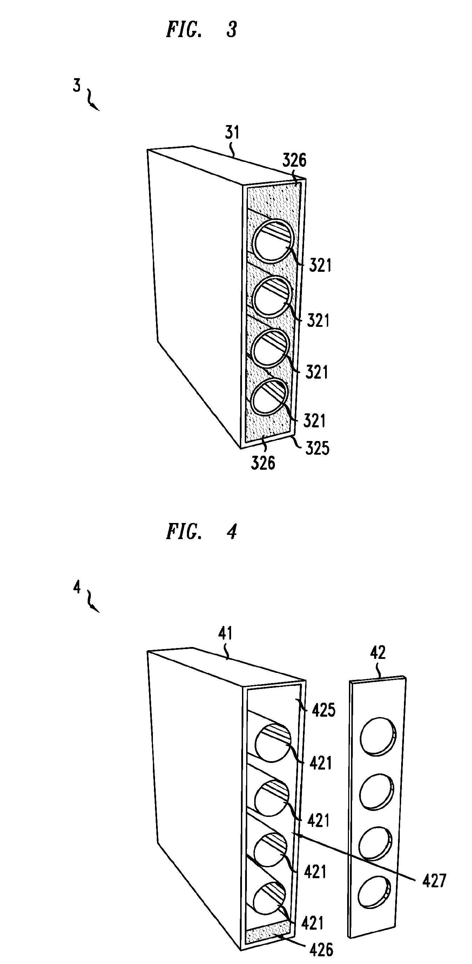

One variant of such embodiments is shown in figure 3 illustrating an exemplary schematic representation of a heat transfer assembly 3 comprising a housing 31 and a plurality of cooling apparatuses. The front cover of the heat transfer assembly is not shown for the sake of simplicity of illustration.

A cooling apparatus from the plurality of cooling apparatuses of the heat transfer assembly 3 comprises a respective air conduit 321 and a respective air mover. The air movers of the heat transfer assembly are also not shown for the sake of simplicity of illustration. Those skilled in the related are will nevertheless understand that the cooling apparatuses of the heat transfer assembly 3 of figure 3 also comprise air movers in a similar fashion as described with reference to figures 2a and 2b, such that an air mover is associated with a respective air conduit 321 to thereby form a cooling apparatus as described with reference to figure 1.

The embodiment shown in figure 3 is similar to the embodiment of figures 2a and 2b with the housing of the heat transfer assembly being hollow and with the difference that the housing 325 of the heat transfer assembly 3 is sealed and is filled with a liquid 326. The air conduits 321 are therefore surrounded, in this embodiment, by the liquid 326. The advantage of this embodiment is that it allows for high flux components to be positioned on the external surfaces of the heat sink as the use of the liquid 326 contributes to a more even spreading of the heat across the outer surfaces of the air conduits 321.

In some embodiments, the liquid 326 may have dielectric properties (not conducting electricity). In such cases, components to be cooled may be fully immersed inside the liquid 326 within the sealed cavity of the housing 325. This technique may further improve the heat transfer efficiency by bringing the cooling solution closer to (e.g. in direct contact with) the hot components, thereby effectively reducing the thermal resistance to ambient. Examples of liquid suitable for use in these embodiments may be hydrofluorocarbon HFC or a hydrofluoroether HFE dielectric liquid.

Other embodiments of a heat transfer assembly having a hollow housing may be envisaged for uses in applications in which the heat transfer assembly may use combined liquid and vapor cooling techniques.

One variant of such embodiments is shown in figure 4 illustrating an exemplary schematic representation of a heat transfer assembly 4 comprising a housing 41 and a plurality of cooling apparatuses. The front cover 42 of the housing 41 is shown in a removed position.

A cooling apparatus from the plurality of cooling apparatuses of the heat transfer assembly 4 comprises a respective air conduit 421 and a respective air mover. Here again, similar to figure 3, the air movers of the heat transfer assembly are not shown for the sake of simplicity of illustration. Those skilled in the related are will nevertheless understand that the cooling apparatuses of the heat transfer assembly 4 of figure 4 also comprise air movers in a similar fashion as described with reference to figures 2a and 2b, such that an air mover is associated with a respective air conduit 421 to thereby form a cooling apparatus as described with reference to figure 1.

The embodiment shown in figure 4 is similar to the embodiment of figure 3, with the difference that the housing 41 of the heat transfer assembly 4 is only partially filled with a liquid 426. At least one air conduit 421 is not inside the liquid 426. Preferably, the rest of the inner space 425 of the housing 41, where the air conduits are located is evacuated (e.g. by vacuum). The housing 41 further comprises a wicking structure 427.

With this configuration, the heat transfer assembly of figure 4 may use multiphase heat transfer. Indeed, in operation, the liquid 426 may evaporate as it is heated by a hot component (not shown) and may condense on the air conduits 421 as the walls of these air conduits absorb the heat from the vapor and are cooled by the flow of air inside the air conduits due to the action of the air movers as described above. A wicking structure, generally shown by reference numeral 427, may be used to transport the condensed liquid to the hot components for further evaporation. The wicking structure may be located at any suitable position where it can make efficient thermal contact with the hot components. In the example of figure 4, the wicking structure is assumed to be on the inner walls of the housing 41. The wicking structure may carry the liquid 426 to the hot component where it can evaporate and then condense on the tubes 421.

In case the electronic component to be cooled is positioned inside the housing 41 a dielectric liquid may be employed and the wicking structure may be positioned on the electronic component itself so that condensed fluid would be carried to the hot component.

The advantage of this embodiment is that it allows the use of multiphase heat transfer which is very efficient and it reduces the thermal resistance between where the heat is generated at the component level and where the heat is ultimately expelled to the atmosphere.

The heat transfer assembly according to the various embodiments of the disclosure may also be combined with liquid/vapor chambers. In such a case, the heat transfer assembly may comprise an integral part in the form of a liquid/vapor chamber, or it may be coupled to an external liquid/vapor chamber. Liquid/vapor chambers are known in the related art and may comprise single phase or two phase properties. In use, such a chamber (either integrated or external to the heat transfer assembly) may be brought into contact with high flux components, thereby allowing for effective cooling of said components.

As the heat transfer assembly according to the various embodiments of the disclosure may be manufactured with small size and weight, it may be mounted directly onto the component to be cooled, for example on a high power computing board within a server chassis. As in these applications there may often be regions of poor airflow on the boards, the solution proposed herein may be useful for a more effective cooling.

In various embodiments, the air conduits 11, 221, 321, 421, may be further optimized through the use of interior surface roughness techniques and/or additional structures within the air conduits. Surface roughness may be obtained by providing irregularities on an otherwise even or smooth surface for example by providing projections, protuberances or breaks on the surface. Additional interior structures may likewise be provided in any convenient shape and size. The roughness and/or additional structures may be configured to increase localized turbulence (mixing) and also to increase surface area on the passage of air though the air conduit which may contribute to cooling.

In various embodiments, the air conduits 11, 221, 321, 421, may be further optimized by providing exterior roughness and/or additional structures to increase the exterior surfaces of the conduits within the housing of the heat transfer assembly. Such increased exterior surfaces may be provided in a similar fashion as described above with respect to interior surfaces and may contribute to enhance heat transfer.

The various embodiments of the present disclosure are provided related to an implementation in which the air mover is positioned at the side from which air enters the air conduit, thereby blowing, by pushing, the air into the air conduit. However, this is only exemplary and the present disclosure is to be understood to cover implementations in which the air mover is positioned at the side from which air exits the air conduit, thereby blowing, by pulling the air out of the air conduit. In the latter case, the operation of the device may be based on the Venturi effect. For example, the air mover may be positioned at the exit of the air conduit such that the direction of air flowing out of the outlet (nozzle) of the air mover is in a cross flow orientation (e.g. perpendicular) with respect to the direction of the flow of the air out of the air conduit. In operation, this configuration may generate low pressure at the region interfacing between the outlet of the air mover and the outlet of the air conduit and as a result causes the air to enter the air conduit at the entrance side and exit from the outlet side of the air conduit.

One advantage of the heat transfer assembly according to the various embodiments disclosed herein is its capability to be manufactured in small size thereby helping to reduce the overall volume, weight and cost of the final product. The heat transfer assembly according to the various embodiments as disclosed herein may also be used for on board applications such as with products already manufactured and placed in operation.

The various embodiments of the present disclosure may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the disclosure.

It should be appreciated by those skilled in the art that any block diagrams herein represent conceptual views of illustrative circuitry embodying the principles of the disclosure.

## Claims

1. A cooling apparatus comprising an air conduit and an air mover configured to generate and drive entrained air through an internal region of the air conduit, the air conduit comprising a thermally conductive wall configured to transfer heat from a surrounding medium to said internal region to dissipate the heat by a flow of the entrained air.

2. The cooling apparatus of claim 1, wherein the thermally conductive wall of the air conduit has a thermal conductivity greater than about 1 W/mK.

3. The cooling apparatus of claim 1 or claim 2, wherein the air mover is positioned at a separation distance from an end of the air conduit.

4. The cooling apparatus of claim 3 wherein the separation distance is determined based on a rate of the air flow generated by the air mover and/or a length of the air conduit along a direction of flow of the air in the air conduit.

5. The cooling apparatus of claim 3 or claim 4, wherein the separation distance is measured in terms of the hydraulic diameter of an air outlet of the air mover wherein the hydraulic diameter is four times the cross sectional area divided by the perimeter of the air outlet of the air mover.

6. The cooling apparatus of claim 5, wherein the separation distance has a value between about 0.5 to about 5 times the hydraulic diameter.

7. The cooling apparatus of any one of the preceding claims wherein the air mover is configured to generate a shear layer having an effective cross-sectional area being substantially equal to a cross-sectional area of the end of the air conduit.

8. The cooling apparatus of any one of the preceding claims wherein an air conduit comprises an interior surface having roughness and/or additional structures within the air conduit.

9. The cooling apparatus of any one of the preceding claims wherein an air conduit comprises an exterior surface having roughness and/or additional structures on an outer surface of the air conduit.

10. A heat transfer assembly comprising the cooling apparatus of any one of claims 1 to 9.

11. The heat transfer assembly of claim 10 further comprising a housing and wherein an air mover of the cooling apparatus is located at a separation distance from the housing.

12. The heat transfer assembly of claim 10 or claim 11 wherein the housing is in the form of a solid block of a thermally conductive heat spreading material.

13. The heat transfer assembly of claim 10 or claim 11 wherein the housing is hollow in the form of a cavity.

14. The heat transfer assembly of claim 13 wherein the housing is sealed and is filled with a liquid wherein the liquid surrounds the air conduits, the liquid having dielectric properties.

15. The heat transfer assembly of claim 13 wherein the housing is sealed and is partially filled with a liquid and at least one air conduit is not located inside the liquid.

16. The heat transfer assembly of any one of claims 10 to 15 comprising a liquid/vapor chamber.
